# EUROPEAN PATENT APPLICATION

(11) **EP 1 280 380 A1**
(43) Date of publication of application: **29.01.2003**
(21) Application number: 01919825.8
(22) Date of filing: 09.04.2001
(51) Int. Cl.: H05B 3/10, H05B 3/20, H05B 3/68, H05B 3/16, H01L 21/66, H01L 21/68

(54) **CERAMIC BOARD**

(30) Priority: 10.04.2000 JP 2000108508
(71) Applicant: Ibiden Co., Ltd., Ogaki-shi, Gifu 503-0917 (JP)
(72) Inventor: HIRAMATSU, Yasuji c/o IBIDEN CO., LTD., Ibi-gun, Gifu 501-0695 (JP); ITO, Yasutaka c/o IBIDEN CO., LTD., Ibi-gun, Gifu 501-0695 (JP)
(74) Representative: Gillard, Marie-Louise
(86) International application number: JP0103027
(87) International publication number: WO01078455

(57) **Abstract**

An objective of the present invention is to provide a ceramic substrate making it possible to control its heating face into even temperature even if through holes into which lifter pins, supporting pins and the like will be inserted are made. The present invention is a ceramic substrate having: a heating element composed of one or more circuit (s) on a surface thereof or inside thereof; and a through hole being made in the ceramic substrate, wherein the heating element circuit is formed in the range of 20 mm or less from the inner wall of the through hole.

## Description

### Technical Field

The present invention relates to a ceramic substrate used mainly in the semiconductor industry, and particularly to a ceramic substrate wherein the temperature evenness of its heating face is superior.

### Background Art

Hitherto, a heater, wafer prober and the like wherein a base material made of a metal such as stainless steel or aluminum alloy is used has been used in semiconductor producing/examining devices and so on, examples of which include an etching device and a chemical vapor deposition device.

However, such a heater made of metal has the following problems.

First, the thickness of the heater plate must be made as thick as about 15 mm since the heater is made of metal. Because in a thin metal plate a bend, a strain and so on are generated on the basis of thermal expansion resulting from heating so that a silicon wafer put on the metal plate is damaged or inclined. However, if the thickness of the heater plate is made thick, a problem that the heater becomes heavy and bulky arises.

The temperature of a face for heating an object to be heated such as a silicon wafer (referred to as a heating face hereinafter) is controlled by changing the voltage or current amount applied to resistance heating elements. However, since the metal plate is thick, the temperature of the heater plate does not follow the change in the voltage or current amount promptly. Thus, a problem that the temperature is not easily controlled is caused as well.

Thus, JP Kokai Hei 4-324276 suggests a ceramic heater wherein aluminum nitride, which is a non-oxide ceramic having a high thermal conductivity and a high strength, is used as a substrate, resistance heating elements and conductor-filled through holes comprising tungsten are made in this aluminum nitride, and nichrome wires as external terminals are brazed thereto.

Since the ceramic substrate whose mechanical strength is high even at high temperature is used in such a ceramic heater, the thickness of the ceramic substrate is made thin so that its heat capacity can be made small. As a result, the temperature of the ceramic substrate can be caused to follow a change in voltage or electric current amount promptly.

Usually, in such a ceramic heater, through holes into which lifter pins, supporting pins and the like will be inserted are made in its ceramic substrate. By inserting the lifter pins, the supporting pins and the like into the through holes, an object to be heated, such as a silicon wafer and the like, can be delivered to a carrier machine, or the silicon wafer and the like can be received from the carrier machine.

### Summary of the Invention

In the ceramic heater having the above-mentioned structure, the through holes are made in areas where no resistance heating elements are present and at positions where the silicon wafer and the like can be successively supported. The through holes and the resistance heating elements are usually formed separately from each other. As a result, cooling spots are easily generated in the vicinity of the through holes. Therefore, a problem that the temperature of the heating face of the ceramic substrate cannot be evenly controlled arises.

The present invention has been made to solve the above-mentioned problems. An objective thereof is to provide a ceramic substrate which makes it possible to control its heating face into even temperature even when through holes into which lifter pins, supporting pins and the like will be inserted and resistance heating elements are formed thereof , so that an object to be heated can be heated into even temperature.

That is, the present invention is a ceramic substrate having: a heating element composed of one or more circuit(s) on a surface thereof or inside thereof; and a through hole being made in the ceramic substrate,
wherein the heating element circuit is formed in the range of 20 mm or less from the inner wall of the through hole.

Since the heating element is made in the region (reference to FIG. 2) of 20 mm or less from the inner wall of the through holes into which the lifter pins, the supporting pins and the like will be inserted in the ceramic substrate of the present invention, the heat amount radiated from the inner wall of the through hole and the heat amount supplied to the vicinity of the through hole from the heating element substantially balance with each other. Thus, even if the temperature of the ceramic substrate rises, no cooling spot is generated in the vicinity of the through hole. Accordingly, the heating face of the ceramic substrate can be controlled into even temperature. Needless to say, when the heating element contacts the region of 20 mm or less from the inner wall of the through hole, the heating element is formed in the region of 20 mm or less from the inner wall of the through hole.

Since the temperature of the inner wall of the through hole falls easily by radiation of heat, a crack may be generated in the through hole by a difference between the degree of the thermal expansion of the inner wall of the through hole and the degree of the thermal expansion inside the ceramic substrate. In the present invention, however, the generation of such a crack can be suppressed.

In the present invention, it is desired that the heating element circuit is formed in the range of 0.1 to 20 mm from the inner wall of the through hole.

If the distance between the inner wall of the through hole and the heating element circuit is less than 0.1 mm, an electric short circuit is generated between the heating element and the lifter pin in case that the lifter pin is made of a metal. Thus, there arise such problems that the body of the device is damaged or the electric power for the heating element cannot be controlled.

This is because: if the distance is less than 0.1 mm, a hot spot, the temperature of which becomes excessively high, is generated in the vicinity of the through hole so that the temperature of the heating face cannot be made even.

Furthermore, the thickness of the ceramic substrate is desirably over 1.5 mm.

### Brief Description of the Drawings

FIG. 1 is a bottom face view schematically illustrating a ceramic heater which is an example of the ceramic substrate of the present invention.
FIG. 2 is a partially enlarged perspective view of the ceramic substrate illustrated in FIG. 1.
FIG. 3 is a partially enlarged sectional view schematically illustrating one part of the ceramic heater illustrated in FIG. 1.
FIG. 4(a) is a vertical sectional view schematically illustrating an electrostatic chuck, and FIG. 4(b) is a sectional view taken along A-A line of the electrostatic chuck illustrated in FIG. 4(a).
FIG. 5 is a horizontal sectional view schematically illustrating another example of an electrostatic electrode embedded in the electrostatic chuck.
FIG. 6 is a horizontal sectional view schematically illustrating further another example of an electrostatic electrode embedded in the electrostatic chuck.
FIG. 7 is a sectional view schematically illustrating a wafer prober which is an example of the ceramic substrate of the present invention.
FIG. 8 is a plane view of the wafer prober illustrated in FIG. 7.
FIG. 9 is a sectional view taken along A-A line in the wafer prober illustrated in FIG. 7.
FIGs. 10(a) to (d) are sectional views schematically illustrating an example of the process for producing the ceramic heater of the present invention.

### Explanation of symbols

- 10: ceramic heater
- 11a: heating face
- 11b: bottom face
- 12a to 12d: resistance heating element
- 13a to 13f: terminal portion
- 14: bottomed hole
- 15: through hole
- 16: lifter pin
- 17: external terminal
- 19: semiconductor wafer (silicon wafer)

### Detailed Disclosure of the Invention

The ceramic substrate of the present invention is a ceramic substrate having: a heating element composed of one or more circuit(s) on a surface thereof or inside thereof; and a through hole being made in the ceramic substrate,
wherein the heating element circuit is formed in the range of 20 mm or less from the inner wall of the through hole.

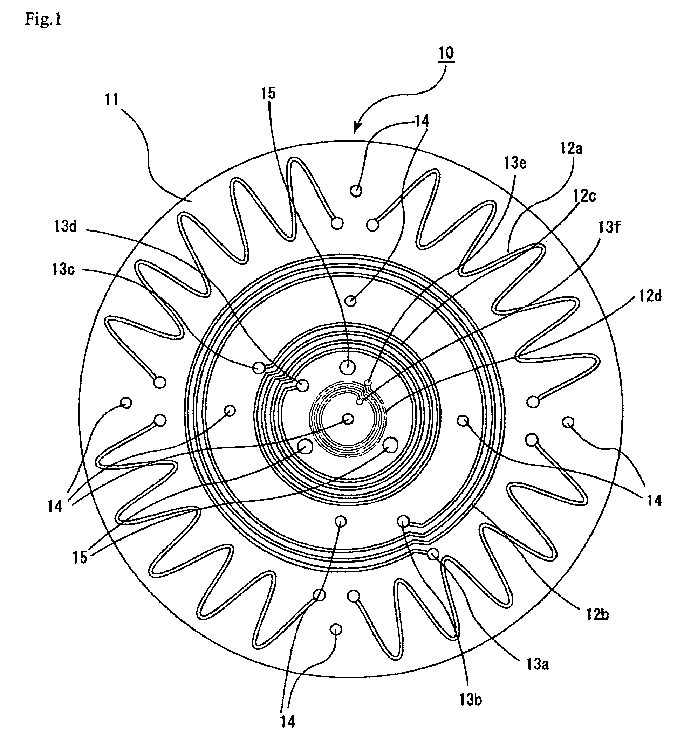

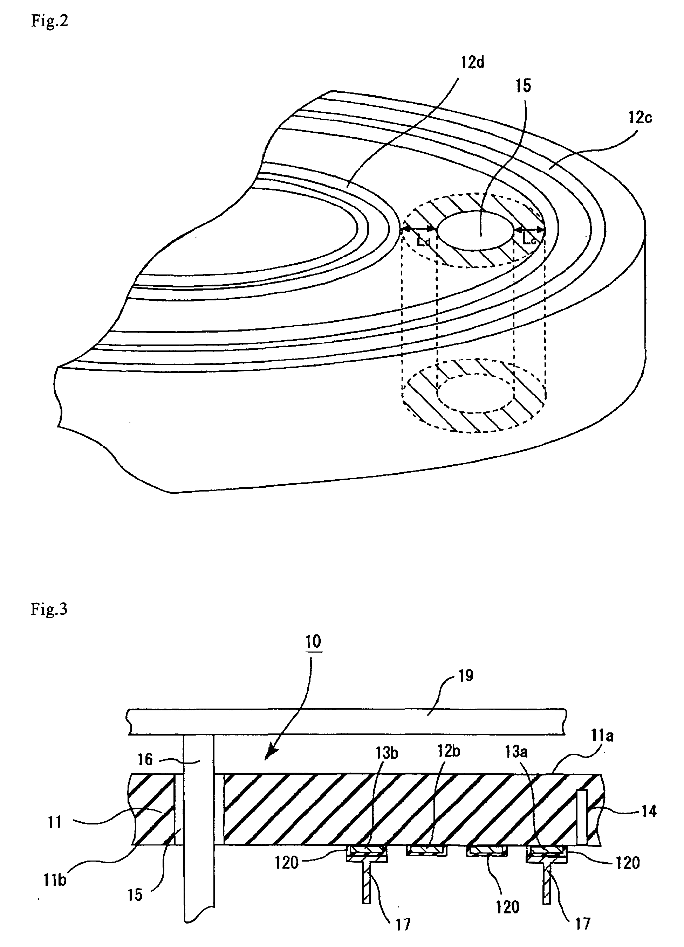

FIG. 1 is a bottom face view schematically illustrating a ceramic heater which is an example of the ceramic substrate of the present invention, FIG. 2 is a partially enlarged perspective view of the ceramic heater illustrated in FIG. 1, and FIG. 3 is a partially enlarged sectional view schematically illustrating one part of the ceramic heater illustrated in FIG. 1.

As illustrated in FIG. 1, a ceramic substrate 11 is formed into a disc form. On the bottom face of the ceramic substrate 11, resistance heating element 12a composed of circuits having a bending line-shape is formed near the circumferential rim portion thereof, and resistance heating elements 12b to 12d having a substantially concentric circles-like shape are formed in the inner portion of the resistance heating element 12a. These circuits are designed to be combined with each other so as to make the temperature of the heating face 11a even.

A metal covering layer 120 is formed on the resistance heating elements 12a to 12d to prevent them from being oxidized. Terminal portions 13a to 13f for input and output are formed at both ends thereof. Furthermore, external terminals 17 are jointed to the terminal portions 13a to 13f with solder and the like, as illustrated in FIG. 3. Sockets having wiring, and so on, which are not illustrated in FIG. 3, are connected to the external terminals 17, so as to attain connection to a power source.

In the ceramic substrate 11, bottomed holes 14, into which temperature-measuring elements will be inserted, are made, and through holes 15, into which lifter pins 16 will be inserted, are made in portions near the center thereof.

The lifter pins 16, on which a silicon wafer 19 can be put, can be moved up and down. In this way, the silicon wafer 19 can be delivered to a non-illustrated carrier machine or the silicon wafer 19 can be received from the carrier machine. Additionally, the silicon wafer 19 can be put on the heating face 11a of the ceramic substrate 11, and be heated, or the silicon wafer 19 can be supported in the state that it is 50 to 5000 µm apart from the heating face 11a, and be heated.

It is allowable to make through holes or concave portions in the ceramic substrate 11, insert supporting pins whose end portions are in an aspire shape or a hemispherical shape into the through holes or the concave portions, fix the supporting pins in the state that the pins are slightly projected from the ceramic substrate 11, and support the silicon wafer 19 by the supporting pins, thereby heating the silicon wafer in the state that the silicon wafer is 50 to 5000 µm apart from the heating face 11a.

In this ceramic heater 10, the shortest distances L_{c} and L_{d} from the inner wall of the through holes 15 to the resistance heating elements 12c and 12d are within the range of 0.1 to 20 mm. It is sufficient that at least one of L_{c} and L_{d} satisfies the above-mentioned condition. But, it is preferred that both of L_{c} and L_{d} satisfy the above-mentioned condition.

If L_{c} and L_{d} are over 20 mm, the heat amount radiated from the through holes 15 exceeds the heat amount supplied from the resistance heating elements 12c and 12d to the through holes 15. Therefore, the temperature of the vicinity of the through holes 15 becomes lower than that of the heating face 11a so that cooling spots are generated in the heating face 11a. On the other hand, if L_{c} and L_{d} are less than 0.1 mm, the heat amount supplied from the resistance heating elements 12c and 12d becomes large so that the lifter pins 16 are excessively heated. Thus, hot spots are easily generated. If L_{c} and L_{d} are over 20 mm, cracks are easily generated by rapid temperature-rise.

Accordingly, if L_{c} and L_{d} are out of the range of 0.1 to 20 mm, the heating face 11a cannot be controlled into even temperature so that an object to be heated, such as a silicon wafer, cannot be controlled into even temperature. The region where is crosshatched in FIG. 2 represents a region from the through holes 15 to L_{c} and L_{d}.

The positions where the through holes 15 are formed are not limited to the region between the resistance heating element 12c and the resistance heating element 12d, and may be in the region between the resistance heating element 12b and the resistance heating element 12c; or the region between the resistance heating element 12a and the resistance heating element 12b. In this case, by adjusting the distances between the resistance heating element 12b and the resistance heating element 12c; and between the resistance heating element 12a and the resistance heating element 12b, the through holes may be made in such a manner that the shortest distance between the inner wall of the through holes 15 and the resistance heating elements present at both sides thereof satisfies the above-mentioned condition. Also, the through holes 15 may be made without changing the positions of the resistance heating elements 12a, 12b nor 12c by adjusting the positions thereof in such a manner that the shortest distance between the inner walls and any one of the resistance heating elements 12a, 12b and 12c satisfies the above-mentioned condition. The diameter of the through holes 15 is preferably from 0.05 to 20 mm.

Examples of the pattern of the resistance heating elements 12 include the combination of the concentric circles-like shape with the bending line shape illustrated in FIG. 1; single patterns such as a concentric circles-like shape, a spiral shape and an eccentric circles-like shape and the like; and combinations of these with a bending line shape and the like.

In the above-mentioned ceramic heater, the number of the circuit(s) composing the above-mentioned resistance heating element(s) is not particularly limited if the number is 1 or more. In order to heat the heating face evenly, it is desired that plural circuits are formed, and it is particularly preferred that a combination of plural concentric circles-like circuits with circuits in a bending line form, as illustrated in FIG. 1, is used.

In the ceramic heater illustrated in FIG. 1, the resistance heating elements are formed on the bottom face, but the resistance heating elements may be formed inside the ceramic substrate.

In case that the resistance heating elements are formed inside the ceramic substrate, the positions for forming them are not particularly limited. It is preferred to form at least one layer thereof at a position from the bottom face of the ceramic substrate up to 60% of the thickness thereof. This is because heat diffuses during the period when the heat is conducted up to the heating face, so that the temperature of the heating face tends to be even.

When the resistance heating elements are formed inside the ceramic substrate or on the bottom face thereof, a conductor containing paste comprising a metal or a conductive ceramic is preferably used.

That is, in case that the resistance heating elements are formed inside the ceramic substrate, a conductor containing paste layer is formed on a green sheet and subsequently such green sheets are laminated and fired to form the resistance heating elements inside. On the other hand. In case that the resistance heating elements are formed on the surface thereof, firstly, firing is usually performed to produce a ceramic substrate and subsequently a conductor containing paste layer is formed on the surface thereof and fired to produce the resistance heating elements.

The above-mentioned conductor containing paste is not particularly limited, and is preferably a paste comprising not only metal particles or a conductive ceramic for keeping electrical conductivity but also a resin, a solvent, a thickener and so on.

Examples of the metal particles preferably include a noble metal (gold, silver, platinum or palladium), lead, tungsten, molybdenum, nickel and the like. These may be used alone or in combination of two or more. This is because: these metals are not relatively easily oxidized, and have a resistance value sufficient for generating heat.

Examples of the above-mentioned conductive ceramic include carbides of tungsten and molybdenum. These may be used alone or in combination of two or more. The particle diameter of these metal particles or the conductive ceramic is preferably from 0.1 to 100 µm. If the particle diameter is too fine, that is, less than 0.1 µm, they are easily oxidized. On the other hand, if the particle diameter is over 100 µm, they are not easily sintered so that the resistance value becomes large.

The shape of the above-mentioned metal particles may be spherical or scaly. When these metal particles are used, they may be a mixture of spherical particles and scaly particles.

In case that the metal particles are scaly or made of a mixture of spherical particles and scaly particles, metal oxides between the metal particles are easily retained and adhesiveness between the resistance heating elements and the ceramic substrate is made sure. Moreover, the resistance value can be made large. Thus, this case is profitable.

Examples of the resin used in the conductor containing paste include epoxy resins, phenol resins and the like. Examples of the solvent are isopropyl alcohol and the like. Examples of the thickener are cellulose and the like.

When the conductor containing paste for the resistance heating elements is formed on the surface of the ceramic substrate, it is preferred to add a metal oxide besides the metal particles. to the conductor containing paste and sinter the metal particles and the metal oxide. By sintering the metal oxide together with the metal particles in this way, the ceramic substrate can be closely adhered to the metal particles.

The reason why the adhesiveness to the ceramic substrate by mixing the metal oxide is improved is unclear, but would be based on the following. The surface of the metal particles or the surface of the ceramic substrate made of a non-oxide is slightly oxidized so that an oxidized film is formed thereon. Pieces of this oxidized film are sintered and integrated with each other through the metal oxide so that the metal particles and the ceramic are closely adhered to each other. In case that the ceramic constituting the ceramic substrate is an oxide, a conductor layer having superior adhesiveness is formed because the surface thereof is naturally made of the oxide.

A preferred example of the metal oxide is at least one selected from the group consisting of lead oxide, zinc oxide, silica, boron oxide (B₂O₃), alumina, yttria, and titania.

These oxides make it possible to improve adhesiveness between the metal particles and the ceramic substrate without increasing the resistance value of the resistance heating elements.

When the total amount of the metal oxides is set to 100 parts by weight, the weight ratio of lead oxide, zinc oxide, silica, boron oxide (B₂O₃), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The ratio is preferably adjusted within the scope that the total thereof is not over 100 parts by weight.

By adjusting the amounts of these oxides within these ranges, the adhesiveness to the ceramic substrate can be particularly improved.

The addition amount of the metal oxides to the metal particles is preferably 0.1 % by weight or more and less than 10 % by weight. The area resistivity when the conductor containing paste having such a structure is used to form the resistance heating elements is preferably from 1 to 45 mΩ/□.

If the area resistivity is over 45 mΩ/□, the calorific value for an applied voltage becomes too small so that, in the ceramic substrate wherein resistance heating elements are set on its surface, its calorific value is not easily ensured.

In case that the resistance heating elements are formed on the surface of the ceramic substrate, a metal covering layer is preferably formed on the surface of the resistance heating elements. The metal covering layer prevents a change in the resistance value based on oxidization of the inner metal sintered body. The thickness of the formed metal covering layer is preferably from 0.1 to 10 µm.

The metal used when the metal covering layer is formed is not particularly limited if the metal is a metal which is non-oxidizable. Specific examples thereof include gold, silver, palladium, platinum, nickel and the like. These may be used alone or in combination of two or more. Among these metals, nickel is preferred.

In case that the resistance heating elements are formed inside the ceramic substrate, no coating is necessary since the surface of the above-mentioned resistance heating elements is not oxidized. The resistance heating elements may be metal wires. As the metal wires, tungsten wires, molybdenum wires and the like may be used. The metal wires may be formed into a spiral form.

The ceramic substrate of the present invention can be used at 100 °C or higher.

In this way, the ceramic substrate of the present invention are provided with the resistance heating elements, and the ceramic substrate can be used as a ceramic heater.

The ceramic material constituting this ceramic substrate is not particularly limited. Examples thereof include nitride ceramics, carbide ceramics, oxide ceramics and the like.

Examples of the nitride ceramics include metal nitride ceramics such as a luminum nitride, silicon nitride, boron nitride, titanium nitride and the like.

Examples of the carbide ceramics include metal carbide ceramics such as silicon carbide, zirconium carbide, titanium carbide, tantalum carbide, tungsten carbide and the like.

Examples of the oxide ceramics include metal oxide ceramics such as alumina, zirconia, cordierite, mullite and the like.

These ceramics may be used alone or in combination of two or more thereof.

Among these ceramics, nitride ceramics and carbide ceramics are more preferred than oxide ceramics. This is because they have a high thermal conductivity.

Aluminum nitride is most preferred among nitride ceramics since its thermal conductivity is highest, that is, 180 W/m K.

The above-mentioned ceramic material may contain a sintering aid. Examples of the sintering aid include alkali metal oxides, alkali earth metal oxides, rare earth element oxides and the like. CaO, Y₂O₃, Na₂O, Li₂O and Rb₂O are particularly preferred among these sintering aids. The content of these sintering aids is desirably from 0.1 to 20 % by weight. Also, alumina may be contained.

In the ceramic substrate according to the present invention, its brightness is desirably N6 or less as the value based on the rule of JIS Z 8721. This is because the ceramic substrate having such a brightness is superior in radiant heat capacity and covering-up ability. The surface temperature of such a ceramic substrate can be accurately measured with a thermoviewer.

The brightness N is defined as follows: the brightness of ideal black is made to 0; that of ideal white is made to 10; respective colors are divided into 10 parts in the manner that the brightness of the respective colors is recognized stepwise between the brightness of black and that of white at equal intensity intervals of perceptual brightness; and the resultant parts are indicated by symbols N0 to N10, respectively.

Actual brightness is measured by comparison with color charts corresponding to N0 to N10. One place of decimals in this case is made to 0 or 5.

The ceramic substrate having such properties can be obtained by incorporating 100 to 5000 ppm of carbon into the ceramic substrate. The carbon may be either amorphous or crystalline. The amorphous carbon makes it possible to suppress a drop in the volume resistivity of the ceramic substrate at high temperature, and the crystalline carbon makes it possible to suppress a drop in the thermal conductivity of the ceramic substrate at high temperature. Therefore, the kind of carbon can be appropriately selected dependently on the purpose of the substrate to be produced, and so on.

The amorphous carbon can be obtained by firing, for example, a hydrocarbon made of only C, H and O, preferably a saccharide in the air. As the crystalline carbon, graphite powder and the like can be used.

Carbon can be obtained by decomposing an acrylic resin thermally in an inert gas atmosphere and then heating and pressing the resin. By changing the acid value of this acrylic resin, the degree of crystallinity (amorphousness) can be adjusted.

The shape of the ceramic substrate is preferably a disc shape. The diameter thereof is preferably 190 mm or more, particularly preferably 200 mm or more, and most preferably 250 mm or more.

This is because: although temperature-evenness is required for the ceramic substrate having a disc shape, the temperature thereof more easily becomes uneven as the substrate having a larger diameter.

The thickness of the ceramic substrate is preferably 50 mm or less, more preferably 20 mm or less, and most preferably from 1 to 5 mm.

Furthermore, the thickness is desirably over 1.5 mm. If the thickness of the ceramic substrate is over 1.5 mm, heat radiated from the through holes becomes large so that the unevenness of the temperature is easily generated.

If the thickness of the ceramic substrate is too thin, a warp is easily generated when the ceramic substrate is heated at high temperature. On the other hand, if the thickness is too thick, the heat capacity thereof becomes too large so that the temperature-rising/falling property thereof deteriorates.

The porosity of the ceramic substrate is preferably 0, or 5% or less. The porosity is measured by Archimedes method.

This is because a drop in the thermal conductivity at high temperature and the generation of a warp can be suppressed.

If necessary, in the present invention a thermocouple may be buried in the ceramic substrate. This is because the thermocouple makes it possible to measure the temperature of the resistance heating element and, on the basis of the resultant data , voltage or current amount is changed so that the temperature can be controlled.

The size of the connecting portions of metal wires of the thermocouples is the same as the strand diameter of the respective metal wires or more, and the size is preferably 0.5 mm or less. Such a structure makes the heat capacity of the connecting portion small, and causes temperature to be correctly and rapidly converted to a current value. For this reason, temperature controllability is improved so that temperature distribution in the heated surface of the wafer becomes small.

Examples of the thermocouple include K, R, B, S, E, J and T type thermocouples, described in JIS-C-1602 (1980) and the like.

The ceramic substrate having the resistance heating elements of the present invention is a ceramic substrate used to perform the production of a semiconductor or the examination thereof. Specific examples of such devices include an electrostatic chuck, a wafer prober, a susceptor, and a hot plate (ceramic heater) and the like.

All of these ceramic substrates have, for example, resistance heating elements having a structure as described with reference to FIG. 1.

The above-mentioned ceramic substrate (hot plate) is a device wherein only resistance heating elements are disposed on a surface of a ceramic substrate or inside the ceramic substrate. This makes it possible to heat an object to be heated, such as a semiconductor wafer and the like, up to a given temperature.

In case that an electrostatic electrode is disposed inside the ceramic substrate of the present invention, the resultant product functions as an electrostatic chuck.

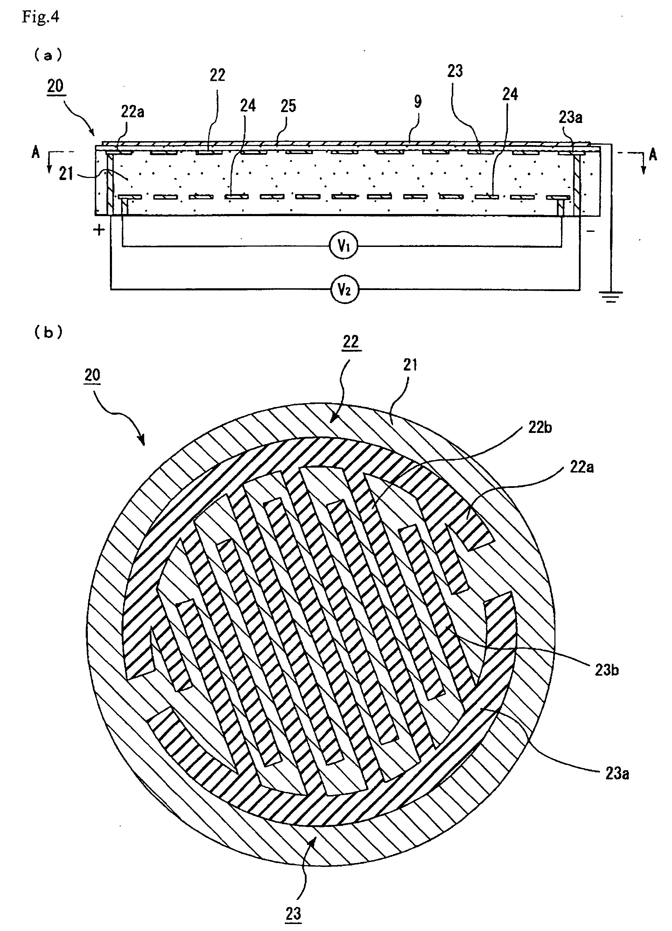

FIG. 4(a) is a vertical sectional view schematically illustrating an electrostatic chuck, and (b) is a sectional view taken along A-A line of the electrostatic chuck illustrated in (a).

In this electrostatic chuck 20, chuckpositive and negative electrode layers 22 and 23 are buried in a ceramic substrate 21. A ceramic dielectric film 25 is made on the electrodes. Resistance heating elements 24 are disposed inside the ceramic substrate 21 so that a silicon wafer 19 can be heated. If necessary, an RF electrode may be buried in the ceramic substrate 21.

Through holes, which are not illustrated in FIG. 4, for lifter pins for carrying the silicon wafer 19 and the like purpose are made in the electrostatic chuck 20. Conditions for forming the through holes are the same as that for forming the above-mentioned ceramic heater.

As shown in (b), the electrostatic chuck 20 is usually made in a circular form when being viewed from the above. The chuck positive electrostatic layer 22 composed of a semicircular arc part 22a and a combteeth-shaped part 22b and the chuck negative electrostatic layer 23 composed of a semicircular arc part 23a and a combteeth-shaped part 23b, which are shown in FIG. 4, are arranged oppositely to each other inside the ceramic substrate 21 so that the combteeth-shaped parts 22b and 23b cross each other.

When this electrostatic chuck is used, the positive side and the negative side of a DC power source are connected to the chuck positive electrostatic layer 22 and the chuck negative electrostatic layer 23, respectively, and then a direct current is applied thereto. In this way, the semiconductor wafer put on this electrostatic chuck is electrostatically adsorbed.

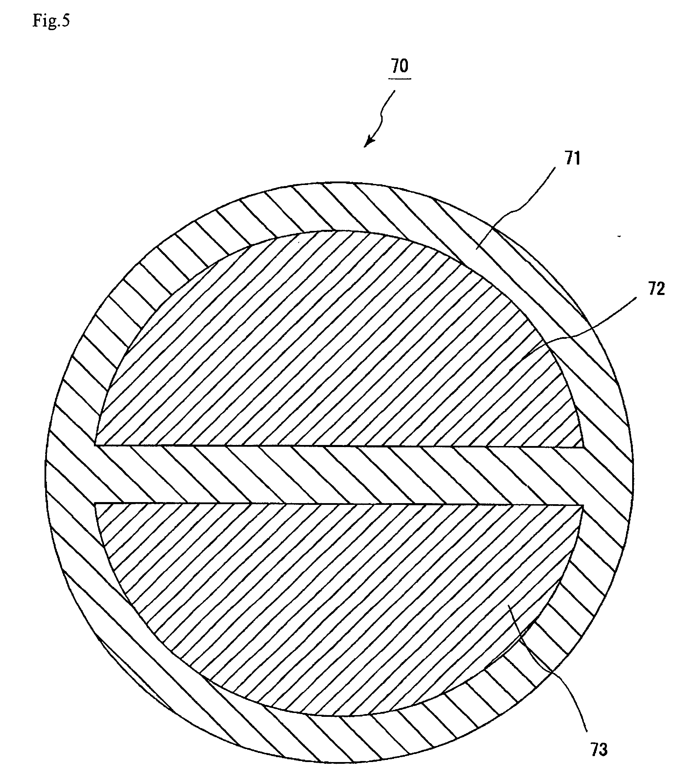

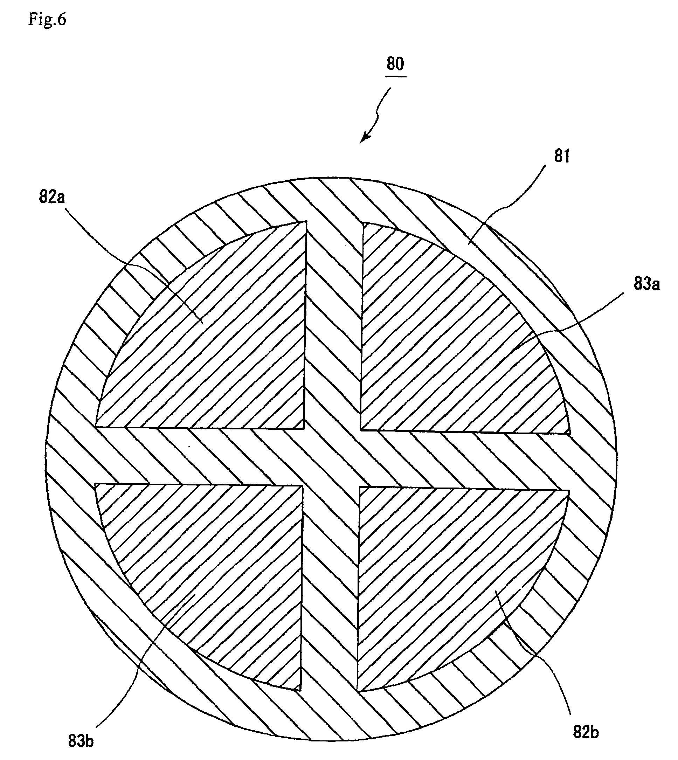

FIGs. 5 and 6 are horizontal sectional views, each of which schematically shows electrostatic electrodes in a different electrostatic chuck. In an electrostatic chuck 70 shown in FIG. 5, a chuck positive electrostatic layer 72 and a chuck negative electrostatic layer 73, each of which in a semicircular form, are formed inside a ceramic substrate 71. In an electrostatic chuck 80 shown in FIG. 6, chuck positive electrostatic layers 82a and 82b and chuck negative electrostatic layers 83a and 83b, each of which has a shape obtained by dividing a circle into 4 parts, are formed inside a ceramic substrate 81. The two chuck positive electrostatic layers 82a and 82b and the two chuck negative electrostatic layers 83a and 83b are formed to cross each other.

In case that an electrode having such a shape that an electrode having a circular shape and the like shape is divided is made, the number of divided pieces is not particularly limited and may be 5 or more. Its shape is not limited to a sector.

In case that a chuck top conductor layer is disposed on a surface of the ceramic substrate of the present invention; and guard electrodes and ground electrodes are disposed inside thereof, the resultant product functions as a ceramic substrate for a wafer prober (referred to merely as a wafer prober hereinafter).

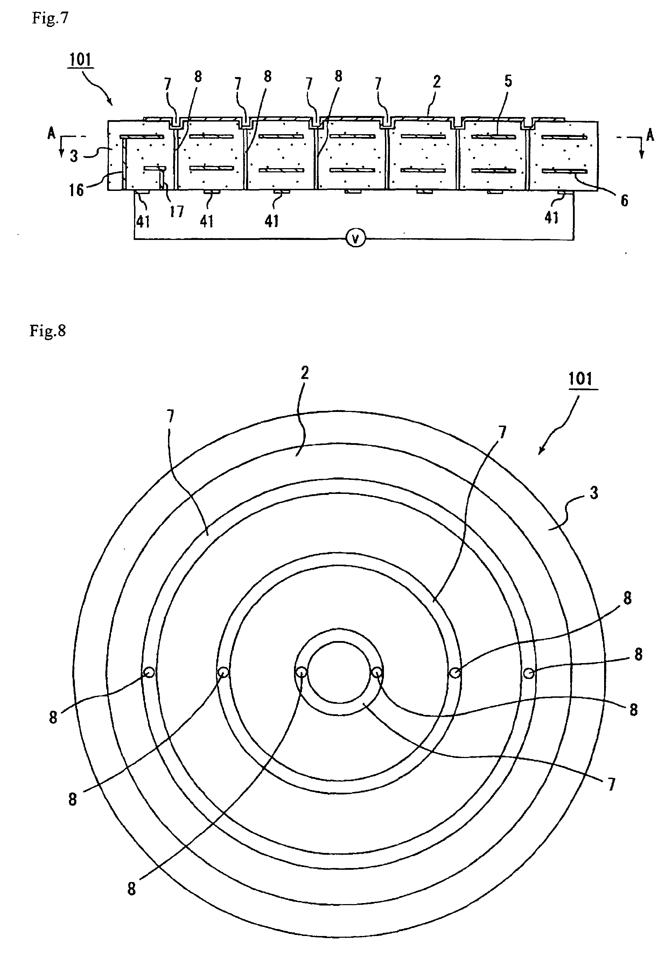

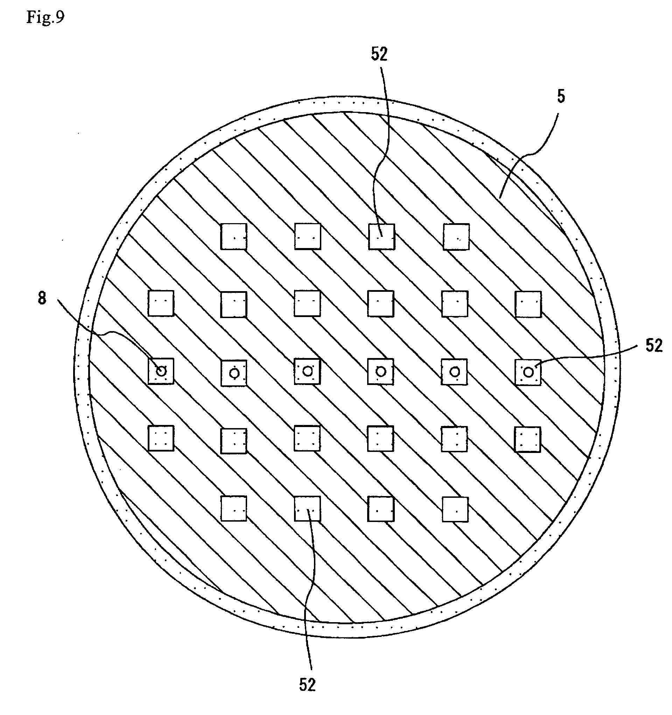

FIG. 7 is a sectional view that schematically shows a wafer prober, which is an example of the ceramic substrate of the present invention. FIG. 8 is a plane view thereof, and FIG. 9 is a sectional view taken along A-A line in the wafer prober shown in FIG. 7.

In this wafer prober 101, grooves 7 in the formof concentric circles are made in the surface of a ceramic substrate 3, which is in a circle form as viewed from the above. Moreover, suction holes 8 for sucking a silicon wafer are made in a part of the grooves 7. A chuck top conductor layer 2 for connecting electrodes of the silicon wafer is formed, in a circular form, in a greater part of the ceramic substrate 3 including the grooves 7.

On the other hand, resistance heating elements 41 wherein a pattern of concentric circles-like is combined with a pattern of bending lines as shown in FIG. 1 are disposed on the bottom face of the ceramic substrate 3 to control the temperature of the silicon wafer. External terminals are connected and fixed to terminal portions formed at both ends of the resistance heating element 41. Inside the ceramic substrate 3, guard electrodes 5 and ground electrodes 6, in the form of a lattice as shown in FIG. 9, are disposed to remove stray capacitors or noises. Rectangular electrode non-forming portions 52 are positioned in the guard electrode 5 in order to adhere the ceramic substrates on and beneath the guard electrode 5 to each other.

Through holes, which are not illustrated in FIG.7, for lifter pins for carrying the silicon wafer and the like purpose are also made in this wafer prober 101. Conditions for forming the through holes are the same as that for forming the above-mentioned ceramic heater.

After a silicon wafer, on which integrated circuits are formed, is put on the wafer prober having such a structure, a probe card having a tester pin is pressed against this silicon wafer. Then, a voltage is applied thereto while the silicone wafer is heated or cooled, so that a continuity test for testing whether the circuit works without problem or not can be performed.

The ceramic substrate of the present invention can be used at 100 to 800 °C.

Next, a process for producing a ceramic heater will be described as an example of the process for producing the ceramic substrate of the present invention.

Firstly, the following describes a process for producing a ceramic heater wherein the heating elements 12 are formed on the bottom face of the ceramic substrate 11 shown in FIG. 1.

### (1) Step of forming the ceramic substrate

A slurry is prepared by blending powder made of a nitride ceramic, such as the above-mentioned aluminum nitride with a sintering aid such as yttria, a binder and so on based on the necessity. Thereafter, this slurry is made into a granular form by spray-drying and the like. The granule is put into a mold and pressed to be formed into a plate form and the like form. Thus, a raw formed body (green) is formed. At this time, carbon may be contained therein.

Next, portions that will be the through holes 15 into which supporting pins 16 for carrying a silicon wafer will be inserted, portions that will be the bottomed holes 14 in which temperature-measuring elements such as thermocouples and the like will be embedded, portion that will be through holes into which supporting pins for supporting the silicon wafer and the like will be inserted, and so on are made in the raw formed body if necessary. After firing, a drill and the like may be used to form bottomed holes or through holes in the produced ceramic substrate.

Next, this raw formed body is heated and fired to be sintered. Thus, a plate made of the ceramic is produced. Thereafter, the plate is processed into a given shape to produce the ceramic substrate 11. The shape of the raw formed body may be such a shape that the sintered body can be used as it is. By heating and firing the raw formed body under pressure, the ceramic substrate 11 having no pores can be produced. It is sufficient that the heating and the firing are performed at sintering temperature or higher. The firing temperature is from 1000 to 2500 °C for nitride ceramics.

### (2) Step of printing a conductor containing paste on the ceramic substrate

A conductor containing paste is generally a fluid comprising metal particles, a resin and a solvent, and has a high viscosity. This conductor containing paste is printed in portions where resistance heating elements are to be arranged by screen printing and the like, to form a conductor containing paste layer. Since it is necessary that the resistance heating elements make the temperature of the whole of the resistance heating elements even, the conductor containing paste is desirably printed into a pattern of concentric circles-like combined with bending lines, as shown in FIG. 1. The conductor containing paste is desirably formed in the manner that a section of the resistance heating elements 12 after the firing is rectangular and flat.

### (3) Firing of the conductor containing paste

The conductor containing paste layer printed on the bottom face of the ceramic substrate 11 is heated or fired to remove the resin and the solvent and sinter the metal particles. Thus, the metal particles are baked onto the bottom face of the ceramic substrate 11 to form the resistance heating elements 12. The temperature for heating and firing is preferably from 500 to 1000 °C.

If the above-mentioned metal oxides are added to the conductor containing paste, the metal particles, the ceramic substrate and the metal oxides are sintered to be integrated with each other. Thus, the adhesiveness between the resistance heating elements and the ceramic substrate is improved.

### (4) Step of forming a metal covering layer

A metal covering layer is desirably deposited on the surface of the resistance heating elements 12.

The metal covering layer can be formed by electroplating, electroless plating, sputtering and the like. From the viewpoint of mass-productivity, electroless plating is optimal.

### (5) Fitting of terminal pins and so on

External terminals for connection to a power source are fitted up to end portions of the pattern of the resistance heating elements 12 with solder and the like. Thermocouples are inserted into the bottomed holes 14. The bottomed holes are sealed with a heat resistant resin such as a polyimide or ceramic, thus, to produce the ceramic heater 10.

An electrostatic chuck can be produced by setting an electrostatic electrode inside the ceramic substrate when the above-mentioned ceramic heater is produced. A wafer prober can be produced by providing a chuck top conductor layer on the heating face and then setting guard electrodes and ground electrodes inside the ceramic substrate.

In case that the electrode is set inside the ceramic substrate, it is advisable that metal foil and the like is embedded in the ceramic substrate. In case that the conductor layer is formed on the surface of the ceramic substrate, the method of sputtering or plating may be used. These methods may be used together.

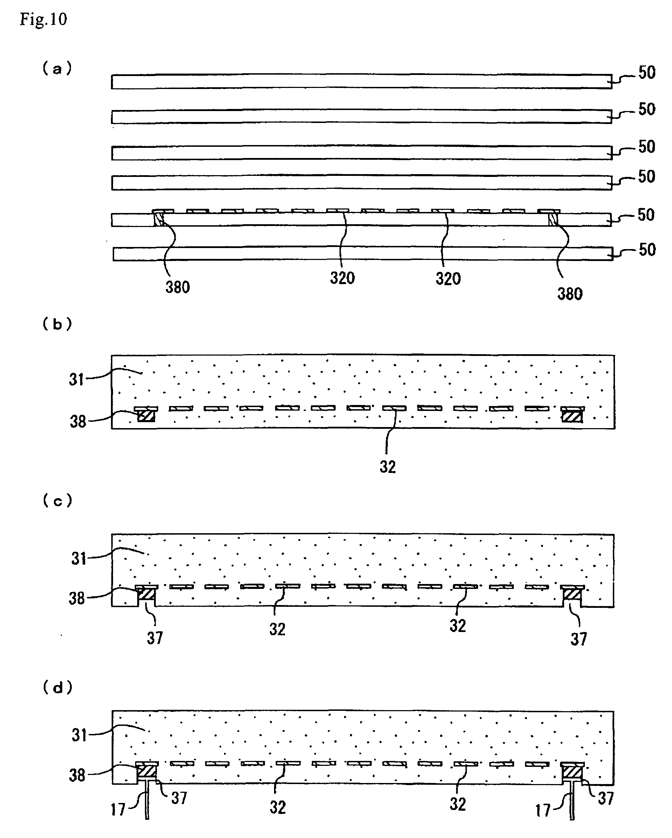

On the basis of FIG. 10, the following will describe a process for producing a ceramic heater wherein resistance heating elements are formed inside a ceramic substrate.

### (1) Step of forming the ceramic substrate

First, powder of a nitride ceramic is mixed with a binder, a solvent and so on to prepare a paste. This is used to form a green sheet.

As the above-mentioned ceramic powder, aluminum nitride, and the like can be used. If necessary, a sintering aid such as yttria may be added.

As the binder, at least one selected from an acrylic binder, ethylcellulose, butylcellosolve, and polyvinyl alcohol is desirable.

As the solvent, at least one selected from α-terpineol and glycol is desirable.

A paste obtained by mixing these is formed into a sheet form by doctor blade process, to form a green sheet 50.

The thickness of the green sheet 50 is preferably from 0.1 to 5 mm.

Next, the following are made in the resultant green sheet if necessary: portions which will be through holes into which lifter pins for carrying a silicon wafer will be inserted; portions which will be bottomed holes in which temperature-measuring elements such as thermocouples will be embedded; portions which will be through holes into which supporting pins for supporting the silicon wafer will be inserted; portions 380 which will be conductor-filled through holes for connecting the resistance heating elements to external terminals; and so on. After a green sheet lamination that will be described later is formed, or after the above-mentioned lamination is formed and fired, the above-mentioned processing may be performed.

### (2) Step of printing a conductor containing paste on the green sheet

A metal paste or a conductor containing paste containing a conductive ceramic is printed on the green sheet 50, to form a conductor containing paste layer 320.

This conductor containing paste contains metal particles or conductive ceramic particles.

The average particle diameter of tungsten particles or molybdenum particles is preferably from 0.1 to 5 µm. If the average particle is less than 0.1 µm or over 5 µm, the conductor containing paste is not easily printed.

Such a conductor containing paste may be a composition (paste) obtained by mixing, for example, 85 to 87 parts by weight of the metal particles or the conductive ceramic particles; 1.5 to 10 parts by weight of at least one binder selected from acrylic binders, ethylcellulose, butylcellosolve and polyvinyl alcohol; and 1.5 to 10 parts by weight of at least one solvent selected from α-terpineol and glycol.

### (3) Step of laminating the green sheets

Green sheets 50 on which no conductor containing paste is printed are laminated on the upper and lower sides of the green sheet 50 on which the conductor containing paste is printed (FIG. 10(a)).

At this time, the number of the green sheet 50 laminated on the upper side is made larger than that of the green sheet 50 laminated on the lower side to cause the position where the resistance heating elements are formed to be biased toward the bottom face.

Specifically, the number of the green sheets 50 laminated on the upper side is preferably from 20 to 50, and that of the green sheets 50 laminated on the lower side is preferably from 5 to 20.

### (4) Step of firing the green sheet lamination

The green sheet lamination is heated and pressed to sinter the green sheets 50 and the inner conductor containing paste layer 320 (FIG. 10(b)).

The heating temperature is preferably from 1000 to 2000 °C, and the pressing pressure is preferably from 10 to 20 MPa. The heating is performed in the atmosphere of an inert gas. As the inert gas, for example, argon, nitrogen and the like can be used.

As described above, after the firing, bottomed holes into which temperature-measuring elements will be inserted may be made. The bottomed holes may be made by drilling or blast treatment such as sandblast after surface-grinding. Also, blind holes 37 are made to make conductor-filled through holes 38 exposed, the conductor-filled through holes 38 being for connection to inner resistance heating elements 32 (FIG. 10(c)). External terminals 17 are inserted into the blind holes 37, and are heated and reflowed. In this way, the external terminals 17 are connected thereto (FIG. 10(d)). The heating temperature is suitably from 90 to 450 °C in the case of treatment with solder. The heating temperature is suitably from 900 to 1100 °C in the case of treatment with brazing material.

Furthermore, thermocouples and the like as temperature-measuring elements are sealed with a heat-resistant resin and the like to produce a ceramic heater.

In this ceramic heater, various operations can be performed, while a silicon wafer and the like is heated or cooled: after the silicon wafer and the like is put thereon; or after the silicon wafer and the like is held by supporting pins.

An electrostatic chuck can be produced by arranging an electrostatic electrode inside the ceramic substrate when the above-mentioned ceramic heater is being produced. A wafer prober can be produced by disposing a chuck top conductor layer on the heating face and then setting a guard electrode and a ground electrode inside the ceramic substrate.

In case that the electrode is set inside the ceramic substrate, it is advisable that a conductor containing paste layer is formed on the surface of the green sheet in the same manner as in the case of forming the resistance heating elements. In case that the conductor layer is formed on the surface of the ceramic substrate, a method of sputtering or plating may be used. These methods may be used together.

### Best Mode for Carrying Out the Invention

The present invention will be described in more detail hereinafter.

### (Example 1) Production of a ceramic heater (reference to FIG. 1)

(1) A composition made of 100 parts by weight of aluminum nitride powder (made by Tokuyama Corp., average particle diameter: 1.1 µm), 4 parts by weight of yttria (Y₂O₃, average particle diameter: 0.4 µm), 12 parts by weight of an acrylic binder and an alcohol was subjected to spray-drying to make granular powder.
(2) Next, this granular powder was put into a mold and formed into a plate-shaped form to obtain a raw formed body (green).
(3) The raw formed body after the above-mentioned working treatment was hot-pressed at 1800 °C and a pressure of 20 MPa to obtain an aluminum nitride sintered body having a thickness of 3 mm.
   Next, this plate was cut out into a disk having a diameter of 210 mm to prepare a plate (ceramic substrate 11) made of the ceramic.
   Next, this formed body was drilled to form through holes into which lifer pins for carrying a semiconductor wafer would be inserted, and bottomed holes (diameter: 1.1 mm, depth: 2 mm) into which thermocouples would be embedded.
(4) A conductor containing paste was printed on the bottom face of the sintered body obtained in the (3) by screen printing. The printed pattern was a pattern wherein the shape of concentric circles-like was combined with the shape of bending lines as illustrated in FIG. 1.
   The used conductor containing paste was Solvest PS603D made by Tokuriki Kagaku Kenkyu-zyo, which is used to form plated through holes in printed circuit boards.
   This conductor containing paste was a silver-lead paste and contained 7.5 parts by weight of oxides made of lead oxide (5% by weight) , zinc oxide (55% by weight), silica (10% by weight), boron oxide (25% by weight) and alumina (5% by weight) per 100 parts by weight of silver. The silver particles had an average particle diameter of 4.5 µm, and were scaly.
(5) Next, the sintered body on which the conductor containing paste was printed was heated and fired at 780 °C to sinter silver and lead in the conductor containing paste and bake them onto the sintered body. Thus, resistance heating elements were formed. The sliver-lead resistance heating elements 12 had a thickness of 5 µm, a width of 2.4 mm and an area resistivity of 7.7 mΩ/□ near its terminal portions.
   About the shortest distances between the inner wall of the through holes into which the lifter pins would be inserted and the resistance heating elements, L_{c} was 1mm and L_{d} was 2 mm.
(6) Next, the sintered body formed in the step (5) was immersed into an electroless nickel plating bath comprising an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer (nickel layer) 120 having a thickness of 1 µm on the surface of the silver-lead resistance heating elements 12.
(7) By screen printing, a silver-lead solder paste (made by Tanaka Kikinzoku Kogyo Co.) was printed on terminal portions for attaining connection to a power source, to form a solder layer.
   Next, external terminals 17 made of koval were put on the solder layer and heated and reflowed at 420 °C to attach the external terminals 17 onto the terminal portions of the resistance heating elements.
(8) Thermocouples for controlling temperature were inserted into the bottomed holes and a polyimide resin was filled into the holes. The resin was cured at 190 °C for 2 hours to obtain a ceramic heater 10 (reference to FIG. 1).

### (Example 2) Production of a ceramic heater

A ceramic heater was produced in the same manner as in Example 1 except that the distances between the inner wall of the through holes 15 and the resistance heating elements were set to 7 mm for L_{c} and 7 mm for L_{d}, respectively.

### (Example 3) Production of a ceramic heater

A ceramic heater was produced in the same manner as in Example 1 except that the distances between the inner wall of the through holes 15 and the resistance heating elements were set to 18 mm for L_{c} and 18 mm for L_{d}, respectively.

### (Example 4) Production of a ceramic heater (reference to FIG. 10)

(1) A paste obtained by mixing 100 parts by weight of aluminum nitride powder (made by Tokuyama Corp., average particle diameter: 1.1 µm), 4 parts by weight of yttria (average particle diameter: 0.4 µm), 12 parts by weight of an acrylic binder, 0.5 part by weight of a dispersant, and 53 parts by weight of alcohols composed of 1-butanol and ethanol was formed into a green sheet 50 having a thickness of 0.47 mm by doctor blade process.
(2) Next, this green sheet 50 was dried at 80 °C for 5 hours, and was subjected to punching to make portions which would be through hole 15, into which lifter pins for carrying a silicon wafer would be inserted, and portions which would be supporting pins for supporting the silicon wafer.
(3) 100 parts by weight of tungsten carbide particles having an average particle diameter of 1 µm, 3.0 parts by weight of an acrylic binder, 3.5 parts by weight of α-terpineol solvent, and 0.3 part by weight of a dispersant were mixed to prepare a conductor containing paste A.
   100 parts by weight of tungsten particles having an average particle diameter of 3 µm, 1.9 parts by weight of an acrylic binder, 3.7 parts by weight of α-terpineol solvent, and 0.2 part by weight of a dispersant were mixed to prepare a conductor containing paste B.
   The conductor containing paste A was printed on the green sheet 50 by screen printing, to form a conductor containing paste layer 320 for resistance heating elements. The printed pattern was a pattern of the shape of concentric circles-like combined with the shape of bending lines as shown in FIG. 1. The width of the conductor containing paste layer was set to 10 mm, and the thickness of the conductor containing paste layer was set to 12 µm, respectively.
   Thirty seven green sheets on which no conductor containing paste was printed were stacked on the upper side (heating surface) of the green sheet subjected to the above-mentioned treatment, and 13 green sheets on which no conductor containing paste was printed were stacked on the lower side thereof, and then the green sheets were laminated at 130 °C and a pressure of 8 MPa (FIG. 10(a)).
(4) Next, the resultant lamination was degreased at 600 °C in nitrogen gas for 5 hours, and hot-pressed at 1890 °C and a pressure of 15 MPa for 10 hours to obtain an aluminum nitride plate 3 mm in thickness. This was cut out into a disc of 230 mm in diameter to prepare a ceramic substrate 11 having therein heating elements 12 having a thickness of 6 µm and a width of 10 mm (aspect ratio: 1666) (FIG. 10(b)). At this time, the distances between the through holes and the resistance heating elements were 7 mm for L_{c} and 7 mm for L_{d}, respectively.
(5) Next, the ceramic substrate 11 obtained in the step (4) was ground with diamond grindstone, and then a mask was put thereon to make bottomed holes 14 for thermocouples in the surface by blast treatment with SiC and the like.
(6) Furthermore, blind holes 37 were made to make conductor-filled through holes 38 exposed (FIG. 10(c)). External terminals 17 were inserted into the blind holes 37, and brazing gold made of Ni-Au alloy (Au: 82% by weight, Ni: 18% by weight) was used to conduct heating and reflowing at 1030 °C, so as to connect the external terminals 17 to the conductor-filled through holes 38 (FIG. 10(d)).
(7) Next, thermocouples for controlling temperature were embedded in the bottomed holes to finish the production of a ceramic heater 10.

### (Comparative Example 1)

A ceramic heater was produced in the same manner as in Example 1 except that the distances between the inner wall of the through holes 15 and the resistance heating elements 12c and 12d were set to 25 mm.

### (Test Example 1)

A ceramic heater was produced in the same manner as in Example 1 except that the distances between the inner wall of the through holes 15 and the resistance heating elements 12c and 12d were set to 0.05 mm.

### (Comparative Example 2)

A ceramic heater was produced in the same manner as in Comparative Example 1 except that the thickness of the ceramic substrate was set to 1.0 mm.

Electric current was sent to the ceramic heaters of Examples 1 to 4, Comparative Examples 1 and 2, and Test Example 1 to heat the heaters up to 200 °C. The temperature of the whole of the heating face was measured with a thermoviewer (Nippon Datum Company, IR162012-0012).

Pins made of stainless-steel were inserted into the through holes, and a voltage of 200 V was applied to the heating elements to raise the temperature thereof to 400 °C. It was checked by means of a multimeter whether or not a short circuit between the pins made of stainless-steel and the heating elements was generated. Furthermore, a voltage was applied thereto so as to raise the temperature rapidly to 400 °C for 45 seconds. It was checked whether or not cracks originating from the through holes were generated. The results are shown in Table 1.

**Table 1**

| | Distance from the through holes (mn) | Temperature difference [ΔT (°C) ] | Short circuit | Crack |
|---|---|---|---|---|
| Example 1 | 2 | 5 | None | None |
| Example 2 | 7, 7 | 6 | None | None |
| Example 3 | 18, 18 | 6 | None | None |
| Example 4 | 7, 7 | 7 | None | None |
| Test Example 1 | 0.05, 0.05 | 10 | Observed | None |
| Comparative Example 1 | 25, 25 | 15 | None | Observed |
| Comparative Example 2 | 25, 25 | 6 | None | Observed |

In the ceramic heaters according to Examples 1 to 3, the whole of the heating face had a substantially even temperature. On the other hand, in the ceramic heater according to Comparative Example 1, the temperature thereof was locally low around the through holes 15 so that cooling spots were generated, and in the ceramic heater according to Test Example 1, the temperature thereof was locally high around the through holes 15 so that hot spots were generated. In both cases, temperature distribution was generated in the heating face. Also, at 400 °C, an electric short circuit was generated between the stainless pins and the resistance heating elements. Further in Comparative Examples 1 and 2, it was proved that a crack was generated in one of the through holes.

Also, this thermoviewer was used to measure a difference (ΔT°C) between the highest temperature and the lowest temperature of the heating face. The results are shown in Table 1. As shown in Table 1, ΔT was small, that is, 5 to 7 °C in Examples 1 to 4 while ΔT was large, that is, 15 °C in Comparative Example 1.

In the ceramic heater according to Comparative Example 2, ΔT was 6°C. In case that the thickness of the ceramic substrate was thin, the temperature difference was small.

In conclusion, the problem of the temperature difference generated in the vicinity of through holes can be overcome in the ceramic substrate according to the present invention if the thickness of the ceramic substrate was 1.5 mm or more.

### Industrially Applicability

As described above, in the ceramic substrate according to the present invention the above-mentioned heating element circuits are formed in the range of 20 mm or less from the inner wall of the above-mentioned through holes. Therefore, no crack or short circuit is generated. No cooling spot or hot spot is generated at the through holes so that the temperature of the entire heating face of the ceramic substrate becomes even.

## Claims

1. A ceramic substrate having: a heating element composed of one or more circuit (s) on a surface thereof or inside thereof; and a through hole being made in the ceramic substrate,
wherein said heating element circuit is formed in the range of 20 mm or less from the inner wall of said through hole.

2. The ceramic substrate according to claim 1,
wherein said heating element circuit is formed in the range of 0.1 to 20 mm from the inner wall of said through hole.

3. The ceramic substrate according to claim 1 or 2,
wherein the thickness of said ceramic substrate is over 1.5 mm.
